# EUROPEAN PATENT APPLICATION

(11) **EP 3 346 279 A1**
(43) Date of publication of application: **11.07.2018**
(21) Application number: 16841555.2
(22) Date of filing: 22.08.2016
(51) Int. Cl.: G01R 27/26

(54) **ELECTROSTATIC DETECTION DEVICE**

(30) Priority: 02.09.2015 JP 2015172980
(71) Applicant: Kabushiki Kaisha Tokai Rika Denki Seisakusho, Ohguchi-cho Niwa-gun Aichi 480-0195 (JP)
(72) Inventor: NAGAO, Takashi, Niwa-gun Aichi 480-0195 (JP)
(74) Representative: Betten & Resch
(86) International application number: PCT/JP2016/074342
(87) International publication number: WO 2017/038523

(57) **Abstract**

An electrostatic detection device 1 that has: a detection electrode part 10; an electrostatic detection circuit part 100 that is a signal detection part into which signals from the detection electrode part 10 are inputted; a first conductive wire part 20 that electrically connects the detection electrode part 10 to the electrostatic detection circuit part 100; and a second conductive wire part 30 that is electrically connected to the electrostatic detection circuit part 100 and that is provided in the vicinity of and parallel to the first conductive wire part 20 but is not electrically connected to the detection electrode part 10.

## Description

### Technical Field

The present invention relates to an electrostatic detection device.

### Background Art

In the related art, a capacitive displacement sensor that can suppress effects of parasitic capacitance to a minimum when measuring capacitive displacement is known (see Patent Document 1, for example).

The capacitive displacement sensor of Patent Document 1, obtains the distance between a pair of electrodes that form an electrostatic capacitance by applying a AC constant voltage to a first electrode of the pair of electrodes to measure the alternating current in the second electrode. The electrodes are connected to a current/voltage converter and a AC constant voltage generator. A coaxial cable is used for the connection, with the inner conductor connected to the current/voltage converter and the AC constant voltage generator as a signal line and the outer conductor grounded.

The coaxial cable transmits an AC voltage signal from a AC constant voltage oscillator to the electrode. Also, the coaxial cable allows electrical shielding so that an outside noise electric field does not enter the AC current signal and electrostatic shielding with the outer conductor so that parasitic capacitance is not caused between the inner conductor and the inner conductor of the coaxial cable.

### Citation List

### Patent Literature

Patent Document 1: JP 2007-85959A

### Summary of Invention

### Technical Problem

In an electrostatic detection device with metal (a dielectric) around the wire from the detection electrode portion to the controller (electrostatic detection circuit portion), which includes an electrostatic detection circuit portion, unnecessary electrostatic capacitance may form. When the value of this unnecessary electrostatic capacitance is high, the sensitivity of the electrostatic detection is affected. Using a coaxial cable such as that described in Patent Document 1 can cause problems in terms of cost and weight. These problems are especially significant when a long coaxial cable is used between a detection electrode portion and an electrostatic detection circuit portion that are located distanced from one another.

An object of the invention is to provide an electrostatic detection device that can reduce or eliminate unnecessary electrostatic capacitance (unnecessary capacitance) generated around the wire from the detection electrode portion to the controller at a low cost. Solution to Problem
(1) An electrostatic detection device according to an embodiment of the invention includes:
   a detection electrode portion;
   a signal detection portion into which signals from the detection electrode portion are inputted;
   a first conducting wire portion electrically connecting the detection electrode portion to the signal detection portion;
   a second conducting wire portion electrically connected to the signal detection portion without being electrically connected to the detection electrode portion, the second conducting wire portion being disposed in close proximity to and parallel with the first conducting wire portion.
(2) The electrostatic detection device according to (1) may have a configuration wherein the signal detection portion is configured to detect an electrostatic capacitance value of the detection electrode portion on the basis of an electrostatic capacitance signal inputted from the first conducting wire portion and an electrostatic capacitance signal inputted from the second conducting wire portion.
(3) The electrostatic detection device according to (1) or (2) may have a configuration wherein the first conducting wire portion and the second conducting wire portion are disposed in close proximity to a metal body.
(4) The electrostatic detection device according to any one of (1) to (3) may have a configuration wherein the signal detection portion is configured to only detect an electrostatic capacitance value formed at the detection electrode portion by subtracting an electrostatic capacitance value inputted from the second conducting wire portion from an electrostatic capacitance value inputted from the first conducting wire portion.
(5) The electrostatic detection device according to any one of (1) to (4) may have a configuration wherein the first conducting wire portion includes a first conductor made of an electrically conductive material and a first insulator formed around the first conductor; the second conducting wire portion includes a second conductor made of an electrically conductive material and a second insulator formed around the second conductor; and the first insulator and the second insulator are in contact along the entire length in a longitudinal direction.

### Advantageous Effects of Invention

According to an embodiment of the invention, an electrostatic detection device can be provided that can reduce or eliminate unnecessary electrostatic capacitance (unnecessary capacitance) generated around the wire from the detection electrode portion to the controller at a low cost.

### Brief Description of Drawings

FIG. 1 is a schematic diagram illustrating a configuration of an electrostatic detection device according to an embodiment of the invention.
FIG. 2 is a schematic diagram illustrating the wiring and unnecessary capacitance for the configuration illustrated in FIG. 1.
FIG. 3 is a graph showing an electrostatic capacitance value C of a detection electrode portion and an electrostatic capacitance value C2 of a second conducting wire portion.
FIG. 4 is a signal chart that shows the electrostatic capacitance value (count value) of the electrostatic detection circuit portion.
FIG. 5 is a schematic diagram illustrating an electrostatic detection device according to an embodiment of the invention applied to a power window of a vehicle.

### Description of Embodiment

### Embodiments of Present Invention

An electrostatic detection device according to an embodiment of the invention has a low cost configuration that can reduce or eliminate unnecessary electrostatic capacitance (unnecessary capacitance) generated around the wire from the detection electrode portion to the electrostatic detection circuit portion (controller) and improve electrostatic detection sensitivity and precision. This configuration also includes a wire harness provided with a dummy wire running parallel with the wire from the detection electrode portion to the controller (electrostatic detection circuit portion). The electrostatic capacitance detected with the dummy wire is determined to be unnecessary capacitance, and this amount is subtracted (offset) to detect the electrostatic capacitance generated in the detection electrode portion.

The electrostatic detection device according to an embodiment of the invention may also have a configuration such that the dummy wire running parallel with the signal line in the wire harness does not connect to the detection electrode portion. The electrostatic detection device can be configured with a typical wire harness, as a result, the configuration has significant effects particularly when the wire is disposed in close proximity to a metal body and when the wire is long. For example, this configuration can be applied to an electrostatic detection device for a power window or the like disposed in the door of a vehicle.

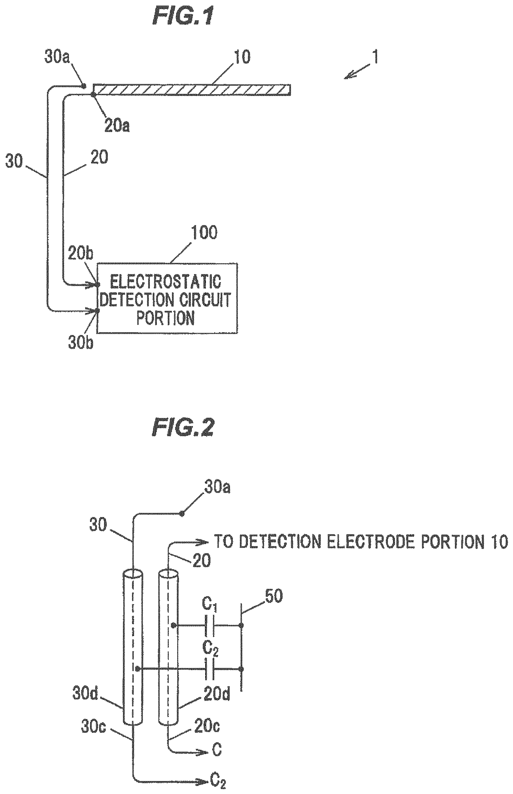

FIG. 1 is a schematic diagram illustrating a configuration of an electrostatic detection device according to an embodiment of the invention.
FIG. 2 is a schematic diagram illustrating the wiring and unnecessary capacitance for the configuration illustrated in FIG. 1.

An electrostatic detection device 1 according to an embodiment of the invention includes a detection electrode portion 10, an electrostatic detection circuit portion 100, i.e., a controller that is a signal detection portion into which signals from the detection electrode portion 10 are inputted, a first conducting wire portion 20 that electrically connects the detection electrode portion 10 to the electrostatic detection circuit portion 100, and a second conducting wire portion 30 electrically connected to the electrostatic detection circuit portion 100 without being connected to the detection electrode portion 10, the second conducting wire portion 30 being disposed in close proximity to and parallel with the first conducting wire portion 20.

### Detection Electrode Portion 10

As illustrated in FIG. 1, the detection electrode portion 10 is an electrode made from electrically conductive material such as copper. When a finger touches or is in close proximity to the surface of the detection electrode portion 10, the electrostatic capacitance value varies. The detection electrode portion 10 can have various shapes, such as a platelike shape and a wire-like shape. Also, depending on where the instrument is installed, a transparent electrode such as an Indium Tin Oxide (ITO) transparent electrode can be used.

### First Conducting Wire Portion 20

The first conducting wire portion 20 is a wire from the detection electrode portion 10 to the electrostatic detection circuit portion 100, and is a wire harness that transmits electric signals. As illustrated in FIGS. 1 and 2, the first conducting wire portion 20 is electrically connected to the detection electrode portion 10 at a first end portion 20a and connected to an input portion of the electrostatic detection circuit portion 100 at a second end portion 20b. A cover portion 20d (first insulator) for insulation is formed around a conducting wire portion 20c (first conductor) that transmits signals. The cover portion 20d is made of resin, and when the first conducting wire portion 20 is placed in close proximity to a metal body, a capacitor C1 (electrostatic capacitance C1) is formed between the first conducting wire portion 20 and an external metal 50 disposed therearound. The capacitor C1 has an electrostatic capacitance value that varies depending on the route of the first conducting wire portion 20. However, because the first conducting wire portion 20 remains in a set position at wiring, the electrostatic capacitance C1 is an approximately constant value.

### Second Conducting Wire Portion 30

As illustrated in FIGS. 1 and 2, the second conducting wire portion 30 is a wire harness disposed in close proximity to and parallel with the first conducting wire portion 20. The second conducting wire portion 30 is not electrically connected to the detection electrode portion 10 at a first end portion 30a proximal to the detection electrode portion 10 and is connected to the input portion of the electrostatic detection circuit portion 100 at a second end 30b.

In a similar manner to that of the first conducting wire portion 20, the second conducting wire portion 30 includes a cover portion 30d (second insulator) for insulation formed around a conducting wire portion 30c (second conductor). The cover portion 30d is made of resin, and when the second conducting wire portion 30 is placed in close proximity to a metal body, a capacitor C2 (electrostatic capacitance C2) is formed between the second conducting wire portion 30 and the external metal 50 disposed therearound.

As illustrated in FIGS. 1 and 2, the second conducting wire portion 30 is disposed in close proximity to and parallel with the first conducting wire portion 20. However, the cover portion 30d and the cover portion 20d may be in contact. In other words, though the positional relationship between the first conducting wire portion 20 and the second conducting wire portion 30 is constant, the first conducting wire portion 20 and the second conducting wire portion 30 are preferably as close as possible to each other.

As illustrated in FIG. 2, the capacitor C1 (electrostatic capacitance C1) is formed between the first conducting wire portion 20 and the external metal 50, and the capacitor C2 (electrostatic capacitance C2) is formed between the second conducting wire portion 30 and the external metal 50. By the first conducting wire portion 20 and the second conducting wire portion 30 being disposed in parallel in close proximity with each other, the electrostatic capacitance C1 and the electrostatic capacitance C2 can be approximately equal.

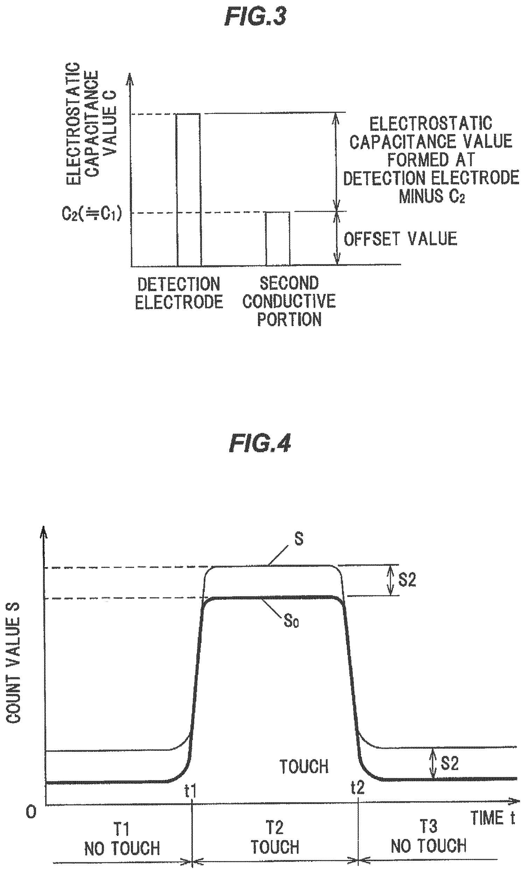

FIG. 3 is a graph showing the electrostatic capacitance value C of the detection electrode portion and the electrostatic capacitance value C2 of the second conducting wire portion.

The electrostatic capacitance value C of the detection electrode portion is the sum of the electrostatic capacitance value formed at the detection electrode portion 10 and the electrostatic capacitance C1 that results from the capacitor C1 formed between the first conducting wire portion 20 and the external metal 50. The value of the electrostatic capacitance C1 cannot be directly detected.

However, though the electrostatic capacitance value C2 of the second conducting wire portion results from the capacitor C2 formed between the second conducting wire portion 30 and the external metal 50, as described above, it can be approximately equal to the electrostatic capacitance value C1 that results from the capacitor C1 formed between the first conducting wire portion 20 and the external metal 50.

The electrostatic capacitance value C1 that results from the capacitor C1 formed between the first conducting wire portion 20 and the external metal 50 is unnecessary electrostatic capacitance value in the detection of the electrostatic capacitance value of the detection electrode portion 10. Thus, as illustrated in FIG. 3, by taking the electrostatic capacitance value C2 described above as an offset value and subtracting the electrostatic capacitance value C2 from the electrostatic capacitance value formed at the detection electrode portion 10, the electrostatic capacitance value formed at the detection electrode portion 10 only can be detected.

### Electrostatic Detection Circuit Portion 100

The electrode configuration illustrated in FIG. 1 is a self-capacitance type electrostatic detection device. The self-capacitance type method involves measuring the electrostatic capacitance value between one electrode and the ground.

The self-capacitance type electrostatic detection circuit portion 100 operates by running a current through the detection electrode portion 10 to measure the voltage. For example, when a finger comes into close proximity with or touches the detection electrode portion 10, the electrostatic capacitance increases.

The electrostatic detection circuit portion 100, i.e., the controller, charges the detection electrode portion 10 with an electric charge in a predetermined period via the first conducting wire portion 20. In a touched state via a finger or the like, the electrostatic capacitance value C varies. This electrostatic capacitance value C inputted from the detection electrode portion 10 is quantized by a counter into a count value S. The touch state is determined on the basis of the count value S.

Additionally, the electrostatic capacitance value C2 from the second conducting wire portion 30 is inputted into the electrostatic detection circuit portion 100 via a different channel. In a similar manner to that of the electrostatic capacitance value C, the electrostatic capacitance value C2 is quantized by a counter into a count value S2. The count value S2 can be taken as the offset value due to the external metal 50.

### Operations

FIG. 4 is a signal chart that shows the electrostatic capacitance value (count value) of the electrostatic detection circuit portion. FIG. 4 shows the count value S of the time periods including from time 0 to time t1, in which the detection electrode portion 10 is not touched, from time t1 to time t2, in which the detection electrode portion 10 is touched, and from time t2 to time t3, in which the detection electrode portion 10 is not touched.

The count value S based on the electrostatic capacitance value C of the detection electrode portion 10 includes the count values for the no touch time period T1 from time 0 to time t1 and time period T3 from time t2 to time t3 and the count value from the touched time period T2 from time t1 to time t2. The values for all of the time periods include the offset amount due to the external metal. In other words, in FIG. 4, the waveform of the count value S indicated with the thin line represents values obtained based on the electrostatic capacitance value C of the detection electrode portion 10.

As described above, the count value S2, which is obtained by quantizing the electrostatic capacitance value C2 via the counter, is a constant value. The waveform of the count value S minus the offset value, i.e., the count value S2, is the count value S₀ indicated by the thick line. The count value S₀ is the electrostatic capacitance value corrected by removing the unnecessary capacitance due to the metal around the first conducting wire portion 20.

In determining whether the detection electrode portion 10 is in a touched state or a close proximity state, a threshold value Sₜₕ is used. Thus, by using the count value S₀ corrected by removing the effects of the offset, electrostatic detection sensitivity and precision can be improved.

### Examples, Application Examples

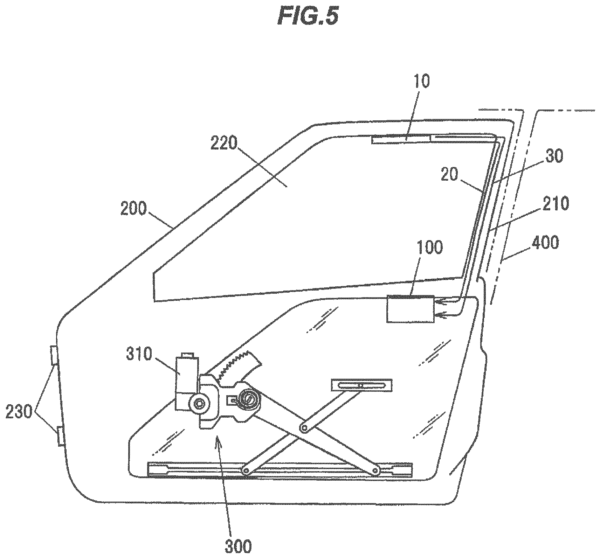

FIG. 5 is a schematic configuration view illustrating the electrostatic detection device according to an embodiment of the invention applied to a power window of a vehicle.

Inside a door frame 210 of a front door 200 of the vehicle, a front glass 220 is installed that can open and close up and down. The front glass 220 is driven up and down by a window regulator 300 to open and close the window.

The front door 200 can be opened and closed via a hinge portion 230. As illustrated in FIG. 5, when the door is closed, the door frame 210 is in close proximity to a center pillar (B pillar) 400. When the door is open, the door frame 210 is distanced from the center pillar 400. Note that the door frame 210 and the center pillar 400 are made of metal.

FIG. 5 illustrates an example system in which the detection electrode portion 10 is installed in the door frame 210 at an inner upper portion, and the window regulator 300 is not actuated by the finger of a passenger touching the detection electrode portion 10. The detection electrode portion 10 is electrically connected to the electrostatic detection circuit portion 100 via the first conducting wire portion 20. Also, the second conducting wire portion 30 is disposed in close proximity to and parallel with the first conducting wire portion 20 but is not electrically connected on the side proximal to the detection electrode portion 10.

The first conducting wire portion 20 and the second conducting wire portion 30 are wired in close proximity to each other inside the door frame 210. As described above, when the door is closed, the door frame 210 is in close proximity to the center pillar 400, thus the first conducting wire portion 20 and the second conducting wire portion 30 are also in close proximity to the center pillar 400. In other words, the first conducting wire portion 20 and the second conducting wire portion 30 have varying positional relationships to the surrounding metal portion depending on whether the front door 200 is open or closed. Accordingly, the unnecessary electrostatic capacitance (unnecessary capacitance) also varies.

Though omitted from FIG. 5, the window regulator 300 is driven by a regulator motor 310 via a window regulator control portion from the electrostatic detection circuit portion 100.

The regulator motor 310 is driven on the basis of the detection of a finger or the like touching or in close proximity to the detection electrode portion 10. Thus, the electrostatic capacitance value of the detection electrode portion 10 and the count value obtained on the basis of this electrostatic capacitance value are preferably values unaffected by the surrounding metal portion.

As described in the embodiment above, the electrostatic capacitance value of the detection electrode portion 10 and the count value obtained on the basis of this electrostatic capacitance value can be obtained by subtracting the electrostatic capacitance value detected at the second conducting wire portion 30 and the count value obtained on the basis of this electrostatic capacitance value as an offset value. Accordingly, only the electrostatic capacitance value from the detection electrode portion 10 can be detected.

Also, the electrostatic capacitance value detected at the second conducting wire portion 30 and the count value obtained on the basis of this electrostatic capacitance value, i.e., offset value, vary depending on whether the front door 200 is open or closed. However, the first conducting wire portion 20 and the second conducting wire portion 30 are wired in close proximity to each other. As a result, the unnecessary capacitance between them and the surrounding metal is approximately equal, and this can be used to perform an offset correction. This allows only the electrostatic capacitance value from the detection electrode portion 10 to be detected, regardless of whether the front door 200 is open or closed.

### Effects of Embodiment

According to an embodiment of the invention, effects such as those described below are achieved.
(1) The electrostatic capacitance value C1 that results from the capacitor C1 formed between the first conducting wire portion 20 and the external metal 50 is unnecessary electrostatic capacitance in the detection of the electrostatic capacitance value of the detection electrode portion 10. Thus, by taking the electrostatic capacitance value C2, which is approximately equal to the electrostatic capacitance value C1, as an offset value and subtracting the electrostatic capacitance value C2 from the electrostatic capacitance value formed at the detection electrode portion 10, the electrostatic capacitance value formed at the detection electrode portion 10 only can be detected. As a result, the sensitivity and precision of electrostatic detection can be improved.
(2) The electrostatic capacitance value between the external metal varies depending on the route of the wire harness and the wiring. However, as the second conducting wire portion 30 is disposed in close proximity to and parallel with the first conducting wire portion 20, C1 ≒ C2. Accordingly, by using C2 as the offset value, the electrostatic capacitance value can be obtained regardless of the route of the wiring by subtracting C2 (offset value), which is the unnecessary electrostatic capacitance, from the electrostatic capacitance value C of the detection electrode portion.
(3) In an embodiment of the invention in which the electrostatic detection device is applied to a door of a vehicle, the door frame of the vehicle is metal, and thus the detection electrode portion 10 is affected by the unnecessary electrostatic capacitance C1. Also, depending on whether the door of the vehicle is open or closed, the positional relationship with the center pillar 400 varies. Thus, the electrostatic capacitance value C and the unnecessary electrostatic capacitance C1 of the detection electrode portion greatly varies. In other words, the electrostatic capacitance values C, C1 vary depending on whether the door of the vehicle is open or closed. However, the second conducting wire portion 30 is disposed in close proximity to and parallel with the first conducting wire portion 20, and C1 ≒ C2. Accordingly, by using C2 as the offset value, the electrostatic capacitance value can be obtained regardless of the route of the wiring by subtracting C1 (offset value), which is the unnecessary electrostatic capacitance, from the electrostatic capacitance value C of the detection electrode portion.
(4) A configuration such as that described above can be applied to an electrostatic detection method for a power window or slide door in which the positional relationship of the first conducting wire portion 20 and the second conducting wire portion 30 and the surrounding metal portion varies, anti-pitch systems, and various switch input system using electrostatic detection.
(5) In a configuration in which the detection electrode portion and the electrostatic detection circuit portion are located distanced from one another, the wiring length is long. However, as a coaxial cable does not need to be used, the cost and weight can be greatly reduced.

Although embodiments and examples of the invention have been described above, these embodiments and examples are merely examples and the invention according to claims is not to be limited thereto. Furthermore, such novel embodiments and examples can be implemented in various other forms, and various omissions, substitutions, changes, and the like can be made without departing from the spirit and scope of the invention. In addition, all combinations of the features described in these embodiments and examples are not necessary to solve the problem. Furthermore, these embodiments and examples are included within the spirit and scope of the invention and also within the scope of the invention described in the claims and equivalents thereof.

### Reference Signs List

1 Electrostatic detection device
10 Detection electrode portion
20 First conducting wire portion
20c Conducting wire portion
20d Cover portion
30 Second conducting wire portion
30c Conducting wire portion
30d Cover portion
50 External metal
100 Electrostatic detection circuit portion

## Claims

1. An electrostatic detection device, comprising:
a detection electrode portion;
a signal detection portion into which signals from the detection electrode portion are inputted;
a first conducting wire portion electrically connecting the detection electrode portion to the signal detection portion; and
a second conducting wire portion electrically connected to the signal detection portion without being electrically connected to the detection electrode portion, the second conducting wire portion being disposed in close proximity to and parallel with the first conducting wire portion.

2. The electrostatic detection device according to claim 1, wherein the signal detection portion is configured to detect an electrostatic capacitance value of the detection electrode portion on the basis of an electrostatic capacitance signal inputted from the first conducting wire portion and an electrostatic capacitance signal inputted from the second conducting wire portion.

3. The electrostatic detection device according to claim 1 or 2, wherein the first conducting wire portion and the second conducting wire portion are disposed in close proximity to a metal body.

4. The electrostatic detection device according to any one of claims 1 to 3, wherein the signal detection portion is configured to only detect an electrostatic capacitance value formed at the detection electrode portion by subtracting an electrostatic capacitance value inputted from the second conducting wire portion from an electrostatic capacitance value inputted from the first conducting wire portion.

5. The electrostatic detection device according to any one of claims 1 to 4, wherein the first conducting wire portion includes a first conductor made of an electrically conductive material and a first insulator formed around the first conductor, and
wherein the second conducting wire portion includes a second conductor made of an electrically conductive material and a second insulator formed around the second conductor, and
wherein the first insulator and the second insulator are in contact along the entire length in a longitudinal direction.
